# EUROPEAN PATENT APPLICATION

(11) **EP 4 808 287 A1**
(43) Date of publication of application: **16.09.2026**
(21) Application number: 24889144.2
(22) Date of filing: 07.11.2024
(51) Int. Cl.: H05K 1/02, H05K 3/46, H05K 5/00, H05K 1/14, H05K 1/11, H05K 1/18, H05K 3/28, H01L 23/498

(54) **FLEXIBLE CIRCUIT BOARD**

(30) Priority: 07.11.2023 KR 20230153130; 05.07.2024 KR 20240088786
(71) Applicant: LG Innotek Co., Ltd., Seoul 07796 (KR)
(72) Inventor: PARK, Ki Tae, Seoul 07796 (KR); LEE, Sang Kyu, Seoul 07796 (KR); KANG, Chae Won, Seoul 07796 (KR); YOON, Hyung Kyu, Seoul 07796 (KR); CHAE, Sung Min, Seoul 07796 (KR); SON, Man Ki, Seoul 07796 (KR)
(74) Representative: DREISS Patentanwälte PartG mbB
(86) International application number: PCT/KR2024/017504
(87) International publication number: WO 2025/100958

(57) **Abstract**

A flexible circuit board according to an embodiment includes a substrate; a circuit pattern disposed on the substrate; and a protective layer disposed on the circuit pattern and including first to third openings, wherein the circuit pattern includes: a first circuit pattern including a first pad portion disposed in the first opening, a second pad portion disposed in the second opening, and a first wiring portion connecting between the first pad portion and the second pad portion, and a second circuit pattern including a third pad portion disposed in the first opening, a fourth pad portion disposed in the third opening, and a second wiring portion connecting between the third pad portion and the fourth pad portion, wherein the protective layer includes a first protruding portion having a first thickness provided in a region adjacent to the third wiring portion, wherein the protective layer has a second thickness smaller than the first thickness in a region where the first protruding portion is not provided, and wherein the first protruding portion is disposed between the third pad portion and the fourth pad portion and extends in a direction in which the fourth pad portion is disposed.

## Description

### Technical Field

An embodiment relates to a flexible circuit board.

### Background Art

Recently, various electronic products are becoming thinner and smaller. Accordingly, it is required to mount semiconductor chips in a narrow region of the electronic product at a high density.

A COF (Chip On Film) includes a circuit board and a chip disposed on the circuit board. The circuit board is flexible. That is, the COF is a flexible circuit board. Accordingly, the COF is applied to a flexible display. For example, the COF can be applied to various wearable electronic devices. In addition, the COF has a fine pitch. Accordingly, the COF is applied to a display having a high resolution.

The chip includes a semiconductor chip. For example, the chip can be an integrated circuit (IC) chip or a large scale integrated circuit (LSI) chip.

The chip is connected to an external circuit board and a display panel through a circuit pattern. For example, pad portions are provided at each one end and other end of the circuit pattern. Either pad portion is electrically connected to a terminal of the chip. Another pad portion is connected to terminals of the external circuit board and the display panel. Accordingly, the chip, the external circuit board, and the display panel are electrically connected through the COF. Accordingly, a signal is transmitted to the display panel through the circuit pattern.

The display panel can be sealed by a sealing layer. The display panel is protected by the sealing layer. The sealing layer can include a resin or a metal.

The flexible circuit board includes a protective layer. The protective layer is disposed on the circuit pattern. When the flexible circuit board and the display panel are connected, the protective layer and the sealing layer can come into contact. Accordingly, the protective layer may be deformed by the sealing layer. For example, a part of the protective layer may be peeled off. Accordingly, the circuit pattern may be exposed to an outside and may be corroded.

Therefore, a flexible circuit board, COF module, and electronic device including the same with a new structure capable of solving the above problems are required.

A patent related to the flexible circuit board is Korean registered patent KR10-0618898 (2006.09.01).

### Disclosure

### Technical Problem

An embodiment provides a flexible circuit board, a COF module, and an electronic device including the same with improved physical reliability and electrical reliability.

In addition, the embodiments provide a flexible circuit board, a COF module, and an electronic device including the same that can further improve adhesion between a protective layer, a substrate, and a circuit pattern.

Technical problems to be solved by the proposed embodiments are not limited to the above-mentioned technical problems, and other technical problems not mentioned may be clearly understood by those skilled in the art to which the embodiments proposed from the following descriptions belong.

### Technical Solution

A flexible circuit board according to an embodiment includes a substrate; a circuit pattern disposed on the substrate; and a protective layer disposed on the circuit pattern and including first to third openings, wherein the circuit pattern includes: a first circuit pattern including a first pad portion disposed in the first opening, a second pad portion disposed in the second opening, and a first wiring portion connecting between the first pad portion and the second pad portion, and a second circuit pattern including a third pad portion disposed in the first opening, a fourth pad portion disposed in the third opening, and a second wiring portion connecting between the third pad portion and the fourth pad portion, wherein the protective layer includes a first protruding portion having a first thickness provided in a region adjacent to the third wiring portion, wherein the protective layer has a second thickness smaller than the first thickness in a region where the first protruding portion is not provided, and wherein the first protruding portion is disposed between the third pad portion and the fourth pad portion and extends in a direction in which the fourth pad portion is disposed.

In addition, the first thickness is more than 1 to 3 times the second thickness.

In addition, the first thickness is more than 10um to 30um.

In addition, the first thickness is 5% to 100% of an average thickness of the protective layer.

In addition, the first protruding portion includes a peak point, the fourth pad portion has a first length, a distance between the fourth pad portion and the peak point has a second-first length, and the second-first length is 5 times or less the first length.

In addition, a distance between the third pad portion and the fourth pad portion has a third length, and the peak point is positioned within 2/3 of the third length.

In addition, the first protruding portion includes a first region in which a thickness increases and a second region in which the thickness decreases, the first region has the second-first length, the second region has a second-second length, and the second-first length is longer than the second-second length.

In addition, the substrate includes a chip mounting region overlapping the first opening along a thickness direction, the protective layer further includes a second protruding portion provided in a region adjacent to the chip mounting region, and the second protruding portion extends along an edge of the chip mounting region.

In addition, the second protruding portion has a third thickness, and the third thickness is greater than an average thickness of the protective layer.

In addition, the third thickness is greater than the second thickness, and the first thickness is greater than the third thickness.

In addition, the flexible circuit board further comprises a dummy pattern disposed on the substrate and spaced apart from the circuit pattern, the circuit pattern includes a third circuit pattern including a fifth pad portion disposed in the first opening, a sixth pad portion disposed in the third opening, and a third wiring portion connecting the fifth pad portion and the sixth pad portion, and the protective layer includes a third protruding portion provided in a region adjacent to an outermost pattern, and the outermost pattern is at least one of the third circuit pattern and the dummy pattern.

In addition, the third protruding portion has a fourth thickness, and the fourth thickness is greater than an average thickness of the protective layer.

In addition, the fourth thickness is greater than the second thickness, and the first thickness is greater than the fourth thickness.

In addition, the protective layer further includes a second protruding portion provided in a region adjacent to the first wiring portion, and the fourth protruding portion is disposed between the first pad portion and the second pad portion and extends in a direction in which the third pad portion is disposed.

In addition, the fourth protruding portion has a fifth thickness, and the fifth thickness is greater than an average thickness of the protective layer.

In addition, the fifth thickness is greater than the second thickness, and the first thickness is greater than the fifth thickness.

Meanwhile, a flexible circuit board according to another embodiment comprises a substrate; a circuit pattern disposed on the substrate; and a protective layer disposed on the substrate and the circuit pattern, and the protective layer includes an overlapping region overlapping the circuit pattern along a thickness direction of the substrate, a non-overlapping region that does not overlap the circuit pattern along the thickness direction, and a boundary region between the overlapping region and the non-overlapping region, and a vertical distance between an upper surface of the overlapping region of the protective layer and an upper surface of the boundary region is less than 30% of a vertical distance between an upper surface of the circuit pattern and a lower surface of the circuit pattern.

In addition, an upper surface of the overlapping region is positioned higher than an upper surface of the non-overlapping region and an upper surface of the boundary region, and an upper surface of the boundary region is positioned higher than an upper surface of the non-overlapping region.

In addition, a vertical distance between an upper surface of the overlapping region of the protective layer and an upper surface of the boundary region is less than 10% of a vertical distance between an upper surface of the overlapping region and an upper surface of the circuit pattern.

In addition, the vertical distance between the upper surface of the overlapping region of the protective layer and the upper surface of the circuit pattern satisfies a range of 11 µm to 30 µm.

In addition, a vertical distance between the upper surface of the overlapping region of the protective layer and the upper surface of the circuit pattern is greater than a vertical distance between the upper surface of the circuit pattern and the lower surface of the circuit pattern.

In addition, a vertical distance between the upper surface of the boundary region of the protective layer and the upper surface of the circuit pattern is greater than a vertical distance between the upper surface of the circuit pattern and the lower surface of the circuit pattern.

In addition, the circuit pattern includes a plurality of patterns elongated in a first direction and spaced apart from each other in a second direction different from the first direction, and the substrate includes a first side end extending in the first direction, and the protective layer is not aligned with the first side end along the thickness direction.

In addition, the protective layer includes a second side end closest to the first side end, and the second side end is located further inward than the first side end of the substrate.

In addition, the circuit pattern includes an outermost circuit pattern disposed most adjacent to a side end of the protective layer and a side end of the substrate, and the non-overlapping region of the protective layer includes an outermost non-overlapping region located between the outermost circuit pattern and the side end of the substrate, and the outermost non-overlapping region includes a protruding portion protruding upward from the upper surface of the protective layer.

In addition, the circuit pattern includes a wiring pattern that transmits an electrical signal, and a dummy pattern that does not transmit the electrical signal, and the outermost circuit pattern is one of the wiring pattern and the dummy pattern.

In addition, an upper surface of the protruding portion of the protective layer has a step from an upper surface of the overlapping region of the protective layer.

In addition, the protective layer includes a first region provided as a single layer, and a second region provided as a double layer, and the overlapping region includes a first overlapping region provided in the first region, and a second overlapping region provided in the second region, and the upper surface of the protruding portion is positioned lower than the upper surface of the second overlapping region.

### Advantageous Effects

A flexible circuit board according to an embodiment includes a protective layer. The protective layer may include a first protruding portion. The first protruding portion is disposed between a third pad portion and a fourth pad portion. The first protruding portion is disposed in a region adjacent to the fourth pad portion. A thickness of the first protruding portion is greater than that of other regions of the protective layer.

At this time, the flexible circuit board is bent and connected to the pad portion of the display panel. At this time, a protective layer and a sealing layer of the display panel may come into contact. The protective layer prevents peeling of a contact region by the first protruding portion. Accordingly, the reliability of the flexible circuit board is improved.

In addition, the protective layer may further include a plurality of protruding portions. The protective layer may further include a second protruding portion. The second protruding portion extends along an edge of a chip mounting region. A thickness of the second protruding portion is greater than that of the other regions. Accordingly, when mounting a chip on the chip mounting region, the protective layer can be prevented from being damaged.

In addition, the protective layer may further include a third protruding portion. The third protruding portion is disposed in a region adjacent to the outermost pattern in the second direction. A thickness of the third protruding portion is greater than that of the other regions. Accordingly, when cutting the flexible circuit board, the protective layer can be prevented from being damaged.

In addition, the protective layer may further include a fourth protruding portion. The fourth protruding portion is disposed in a region adjacent to the second pad portion. A thickness of the fourth protruding portion is greater than that of the other regions. Accordingly, when cutting the flexible circuit board, the protective layer can be prevented from being damaged.

In addition, the embodiment may improve the adhesion between the protective layer and the substrate, and/or the circuit pattern, thereby improving the mechanical reliability and/or the electrical reliability of the flexible circuit board. In particular, the embodiment may improve the adhesion between the protective layer and the substrate and the circuit pattern by changing a thickness of the protective layer, the concentration of the curing agent of the protective layer, and a curing condition of the protective layer, thereby improving the mechanical reliability and/or the electrical reliability of the flexible circuit board.

The protective layer according to the embodiment may have a thickness that is increased in a vertical direction, a higher concentration of a curing agent, and further an increased curing time, compared to the protective layer of the comparative example. Through this, the embodiment can allow for increasing a penetration time of moisture or contaminants from the upper surface of the protective layer to the lower surface of the protective layer in a high temperature or high humidity environment. In other words, a problem such as peeling of the protective layer can occur when moisture or contaminants penetrate an interface between the protective layer and the substrate, or an interface between the protective layer and the circuit pattern. Therefore, the embodiment can delay the penetration of moisture or contaminants by increasing the thickness of the protective layer, thereby further improving the adhesion between the protective layer, the substrate, and the circuit pattern.

In addition, the embodiment can increase the concentration of the curing agent that constitutes the protective layer compared to the comparative example. That is, in the embodiment, the concentration of the curing agent provided in the protective layer is increased by 30% or more compared to the concentration of the curing agent in the comparative example. Accordingly, the embodiment can minimize uncured components in materials that constitute the protective layer. Furthermore, the embodiment increases the concentration of the curing agent in the protective layer to increase a polymer chain quality, thereby minimizing the penetration of moisture or contaminants due to a volume reduction within the protective layer.

Furthermore, the embodiment can change curing conditions of the protective layer. That is, the embodiment can increase a curing time of the protective layer, thereby minimizing a content of uncured components within the protective layer, thereby reducing a volume within the protective layer. Furthermore, the embodiment can increase a cross-link bonding strength through the strengthening of the curing of the protective layer. Therefore, the embodiment can delay structural destruction of the protective layer due to migration, and further delay migration growth.

In addition, the embodiment can increase the thickness of the protective layer, increase the concentration of the curing agent, and increase the curing time, thereby preventing the rapid decrease in the height of the protective layer in the above-described boundary region. That is, the embodiment can minimize the height difference between the boundary region and the overlapping region of the protective layer, thereby effectively preventing moisture, contaminants, and metal ions from penetrating into the boundary region of the protective layer, and thereby further improving the adhesion between the protective layer, the substrate, and the circuit pattern.

Therefore, the embodiment can provide a protruding portion in an outermost non-overlapping region of the protective layer. Here, the protruding portion can be a protruding surface protruding upward from the upper surface of the protective layer. At this time, a height of the protruding portion can be greater than the height of other regions of the protective layer. Specifically, the height of the protruding portion of the protective layer can be greater than a height of the overlapping region of the protective layer. For example, the protruding portion of the protective layer can have the largest height or thickness in the entire region of the protective layer. Through this, the embodiment can easily prevent moisture, contaminants, and metal ions from penetrating through the outermost overlapping region of the protective layer.

### Description of Drawings

FIG. 1 and FIG. 2 are cross-sectional views of a COF module according to a first embodiment.
FIG. 3 is a top view of a flexible circuit board according to a first embodiment.
FIG. 4 is a cross-sectional view taken along a region A-A' of FIG. 3.
FIG. 5 and FIG. 6 are cross-sectional views taken along a region B-B' of FIG. 3.
FIG. 7 is a cross-sectional view taken along a region C-C' of FIG. 3.
FIG. 8 is a cross-sectional view taken along a region D-D' of FIG. 3.
FIG. 9a is an enlarged cross-sectional view of a region E of FIG. 3 according to a second embodiment.
FIG. 9b is a drawing showing a scanning electron microscope photograph of FIG. 9a according to a second embodiment.
FIG. 9c is a drawing showing a scanning electron microscope photograph of a region E of FIG. 9b according to a comparative example.
FIG. 10a is a drawing showing an analysis image of a protective layer of a flexible circuit board according to a comparative example.
FIG. 10b is a drawing showing an analysis image of a protective layer of a flexible circuit board according to a second embodiment.
FIGS. 11 to 13 are drawings of an electronic device including a flexible circuit board according to an embodiment.

### Modes of the Invention

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and replaced.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", or "coupled" to another element, it may include not only when the element is directly "connected" to, or "coupled" to other elements, but also when the element is "connected", or "coupled" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

In addition, in the following description, a first direction (1D) is a direction in which a pad portion of the display panel and a pad portion of the circuit board face each other. In addition, a second direction 2D is a direction perpendicular to the first direction (1D).

Hereinafter, a flexible circuit board according to an embodiment and a COF module including the same will be described with reference to the drawings.

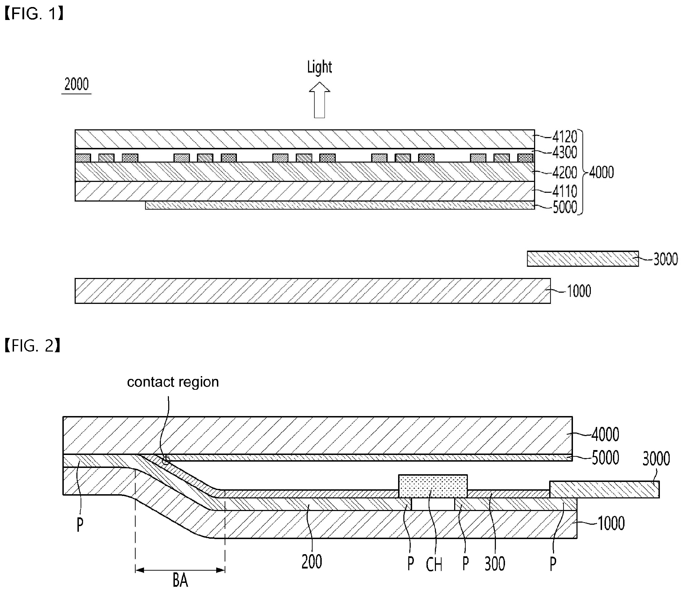

FIG. 1 and FIG. 2 are cross-sectional views of a COF module according to an embodiment.

Referring to FIG. 1, a COF module 2000 includes a flexible circuit board 1000, a circuit board 3000, and a display panel 4000.

The display panel 4000 includes a first substrate 4110 and a second substrate 4120. A TFT 4200 and a light source 4300 are disposed between the first substrate 4120 and the second substrate 4220. A light source 4300 may include an organic light-emitting element. For example, the display panel 4000 may be an OLED panel.

A sealing layer 5000 is disposed at an outside of the display panel. The sealing layer 500 prevents external oxygen or moisture from penetrating into the inside of the light source 4300.

Referring to FIG. 2, the circuit board 3000 and the display panel 4000 are connected to a flexible circuit board 1000. For example, the circuit board 3000 and the display panel 4000 may be connected on a same surface of the flexible circuit board 1000. Accordingly, A chip CH, the circuit board 3000 and the display panel 4000 are electrically connected.

The flexible circuit board 1000 includes a circuit pattern 200, a pad portion (P), and a protective layer 300. The protective layer 300 is disposed on the circuit pattern 200. The protective layer 300 is not disposed on the pad portion (P). The pad portion (P) is connected to the circuit board 3000, the display panel 4000, and the chip CH.

The flexible circuit board 1000 includes a bending region BA. The circuit board 3000, the display panel 4000, and the chip CH are disposed on one surface of the flexible circuit board 1000 by the bending region BA.

When the flexible circuit board 1000 and the display panel 4000 are connected, the protective layer 300 and the sealing layer 5000 may come into contact. Accordingly, the protective layer 300 may be damaged by the sealing layer 5000. As a result, the protective layer 300 may be partially peeled off at a contact region between the protective layer 300 and the sealing layer 5000. By this, a region where the circuit pattern 200 is exposed to an outside may be formed. Therefore, the reliability of the flexible circuit board and the COF module including the flexible circuit board may decrease.

The flexible circuit board 1000 according to the embodiment controls a thickness of the protective layer 300, thereby solving the above-mentioned problem.

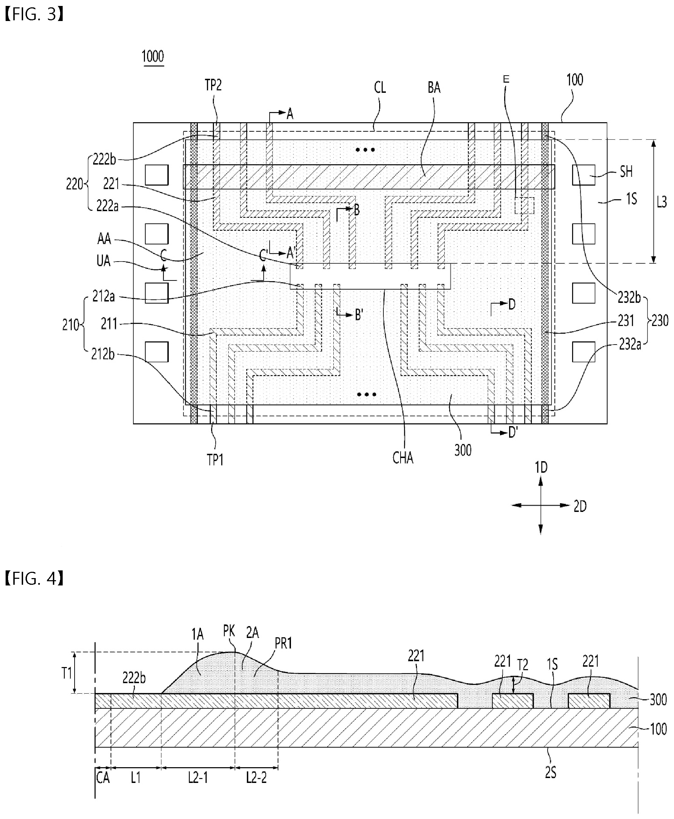

Referring to FIG. 3, the flexible circuit board 1000 includes a substrate 100, a circuit pattern, and a protective layer 300.

The substrate 100 includes a first surface 1S and a second surface 2S opposite to the first surface 1S. A circuit pattern and a protective layer 300 are disposed on the first surface 1S.

The substrate 100 includes a cutting line CL. The flexible circuit board 1000 is cut along the cutting line CL. For example, a circuit pattern, a metal pattern, a protective layer, and a chip are disposed on the substrate 100. Then, the substrate 100 is cut along the cutting line CL. Accordingly, the COF module is manufactured. Accordingly, an edge of the COF module becomes the cutting line CL.

The substrate 100 includes an effective region AA and an ineffective region UA. In detail, the first surface 1S includes an effective region AA and an ineffective region UA.

The effective region AA and the ineffective region UA are separated by the cutting line CL. In detail, the effective region AA is an inner region of the cutting line CL. In addition, the ineffective region UA is an outer region of the cutting line CL.

A circuit pattern, a protective layer, and a chip are disposed in the effective region AA. In addition, a dummy pattern and a sprocket hole SH are disposed in the ineffective region UA. The dummy pattern increases a strength of the substrate 100. In addition, the flexible circuit board 1000 is rolled or unrolled in a roll-to-roll manner by the sprocket hole SH.

The substrate 100 includes a chip mounting region CHA. The chip mounting region CHA is disposed on the first surface 1S. The chip mounting region CHA is disposed on the effective region AA. A chip CH is disposed in the chip mounting region CHA. In addition, pad portions of the circuit pattern are disposed inside the chip mounting region CHA. In addition, the protective layer 300 is not disposed on the chip mounting region CHA. That is, the protective layer 300 includes a first opening provided corresponding to the chip mounting region CHA. In addition, the protective layer 300 may further include a second opening and a third opening.

That is, the substrate 100 may include a substrate connection region (not shown) to which a circuit board is connected. In addition, the substrate 100 may include a panel connection region (not shown) to which the display panel is connected. For example, the substrate 100 may include a first side end and a second side end facing each other in the first direction 1D. The substrate 100 may include a substrate region provided in a region adjacent to the first side end. In addition, the substrate 100 may include a panel connection region provided in a region adjacent to the second side end. The protective layer 300 may not be disposed on the substrate connection region. That is, the protective layer 300 may include a second opening that overlaps the substrate connection region along a vertical direction. In addition, the protective layer 300 may not be disposed on the panel connection region. That is, the protective layer 300 may include a third opening that overlaps the panel connection region along a vertical direction.

The substrate 100 includes a flexible material. For example, the substrate 100 may include a polyimide (PI). However, the embodiment is not limited thereto. The substrate 100 may include a polymer material including polyethylene terephthalate (PET) or polyethylene naphthalate (PEN). Accordingly, the flexible circuit board may be applied to various electronic devices including a curved display device.

The substrate 100 may have a thickness of 20 µm to 100 µm. For example, the substrate 100 may have a thickness of 25 µm to 50 µm. For example, the substrate 100 may have a thickness of 30 µm to 40 µm. If the thickness of the substrate 100 exceeds 100 µm, an overall thickness of the flexible circuit board increases. As a result, the flexible characteristics of the flexible circuit board may be reduced. In addition, If the thickness of the substrate 100 is less than 20 um, the substrate 100 may be damaged by heat and pressure applied to the substrate when mounting the chip on a flexible circuit board.

The circuit pattern and the protective layer 300 are disposed on the substrate 100. In detail, the circuit pattern and the protective layer 300 are disposed on the first surface 1S. In detail, the circuit pattern and the protective layer 300 are disposed on at least one of the effective region AA and the ineffective region UA.

The circuit pattern includes a first circuit pattern 210, a second circuit pattern 220, and a third circuit pattern 230.

Referring to FIG. 1, the first circuit pattern 210 includes a first wiring portion 211, a first pad portion 212a, and a second pad portion 212b. The first wiring portion 211, the first pad portion 212a, and the second pad portion 212b may include a same material. In addition, the first wiring portion 211, the first pad portion 212a, and the second pad portion 212b may be formed integrally.

The first pad portion 212a is disposed inside the chip mounting region CHA. Accordingly, the first pad portion 212a is connected to the terminal of the chip. Accordingly, the first circuit pattern 210 and the chip are connected.

The second pad portion 212b is disposed outside the chip mounting region CHA. The second pad portion 212b is connected to a pad portion of the circuit board 3000. Accordingly, the first circuit pattern 210 and the circuit board 3000 are connected.

The first wiring portion 211 is disposed between the first pad portion 212a and the second pad portion 212b. The first wiring portion 211 connects the first pad portion 212a and the second pad portion 212b. Accordingly, the chip CH and the circuit board 3000 are connected. Therefore, a signal generated from the chip CH is transmitted to the circuit board 3000.

The first circuit pattern 210 may further include a test pad portion. In detail, a first test pad portion TP1 is disposed in the non-valid region UA. The first wiring portion 211, the first pad portion 212a, the second pad portion 212b, and the first test pad portion TP1 may be formed integrally.

Before connecting the circuit board and the second pad portion 212b, the first circuit pattern 210 may be tested by the first test pad portion TP1. For example, whether the first circuit pattern is open or shorted may be checked through the first test pad portion TP1.

The second circuit pattern 220 includes a second wiring portion 221, a third pad portion 222a, and a fourth pad portion 222b. The second wiring portion 221, the third pad portion 222a, and the fourth pad portion 222b may include a same material. In addition, the second wiring portion 221, the third pad portion 222a, and the fourth pad portion 222b may be formed integrally.

The third pad portion 222a is disposed inside the chip mounting region CHA. Accordingly, the third pad portion 222a is connected to the terminal of the chip. Accordingly, the second circuit pattern 220 and the chip CH are connected.

The fourth pad portion 222b is disposed outside the chip mounting region CHA. The fourth pad portion 222b is connected to the pad portion of the external display panel 4000. Accordingly, the second circuit pattern 220 and the display panel 4000 are connected.

The second wiring portion 221 is disposed between the third pad portion 222a and the fourth pad portion 222b. The second wiring portion 221 connects the third pad portion 222a and the fourth pad portion 222b. Accordingly, the chip CH and the display panel 4000 are connected. Accordingly, a signal generated from the chip CH is transmitted to the display panel 4000.

The second circuit pattern 220 may further include a test pad portion. In detail, a second test pad portion TP2 is disposed in the non-effective region UA. The second wiring portion 221, the third pad portion 222a, the fourth pad portion 222b, and the second test pad portion TP2 may be formed integrally.

Before connecting the circuit board and the fourth pad portion 222b, the second circuit pattern 220 may be tested by the second test pad portion TP2. For example, whether the second circuit pattern is open or shorted can be checked through the second test pad portion TP2.

The third circuit pattern 230 includes a third wiring portion 231, a fifth pad portion 232a, and a sixth pad portion 232b. The third wiring portion 231, the fifth pad portion 232a, and the sixth pad portion 232b may include the same material. In addition, the third wiring portion 231, the fifth pad portion 232a, and the sixth pad portion 232b may be formed integrally.

The fifth pad portion 232a and the sixth pad portion 232b are disposed outside the chip mounting region CHA. The fifth pad portion 232a may be connected to the pad portion of the circuit board 2000. In addition, the sixth pad portion 232b may be connected to the pad portion of the display panel 4000.

The third wiring portion 231 is disposed between the fifth pad portion 232a and the sixth pad portion 232b. The third wiring portion 231 connects the fifth pad portion 232a and the sixth pad portion 232b. Accordingly, the circuit board 3000 and the display panel 4000 are connected.

The third circuit pattern 230 may be a by-pass circuit. For example, the third circuit pattern 230 may be a power supply pattern. Accordingly, the circuit board and the display panel may be supplied with power by the third circuit pattern 230.

The third circuit pattern 230 may include a plurality of third circuit patterns spaced apart in the second direction 2D. A line width and spacing of the third circuit pattern 230 may be larger than a line width and spacing of the first circuit pattern 210. In addition, the line width and spacing of the third circuit pattern 230 may be larger than the line width and spacing of the second circuit pattern 220.

Although not shown in the drawing, at least one dummy pattern may be placed on the effective region AA.

The dummy pattern can prevent the flexible circuit board 1000 from bending. In addition, the spacing and line width of the circuit pattern can be made uniform by the dummy pattern.

The dummy pattern can include a same material as the circuit pattern. A line width of the dummy pattern can be the same as or different from the circuit pattern. The dummy pattern is not connected to the chip CH, the circuit board 3000, and the display panel 4000.

The protective layer 300 is disposed on the first surface 1S. Accordingly, the protective layer 300 is disposed on the first circuit pattern 210, the second circuit pattern 220, and the third circuit pattern 230. The protective layer 300 is disposed on a region excluding a region where the first pad portion 212a, the second pad portion 212b, the third pad portion 222a, the fourth pad portion 222b, the fifth pad portion 232a, and the sixth pad portion 232b are disposed. In addition, the protective layer 300 is not disposed on the chip mounting region CHA.

Referring to FIG. 4, the protective layer 300 includes a region having a large thickness. For example, the protective layer 300 includes a protruding portion. Therefore, the protective layer includes a protruding region including the protruding portion, and a non-protruding region not including the protruding portion.

The protruding portion may be disposed at an edge of the protective layer 300. The protruding portion may be divided into a plurality of protruding portions depending on a position. For example, a first protruding portion PR1 may be disposed on a region adjacent to the fourth pad portion 222b. The first protruding portion PR1 may extend in a direction in which the fourth pad portions 222b are disposed. In detail, the first protruding portion PR1 may extend in the second direction 2D.

The first protruding portion PR1 is disposed between the third pad portion 222a and the fourth pad portion 222b. The first protruding portion PR1 may be disposed between the fourth pad portion 222b and the chip mounting region CHA. The first protruding portion PR1 may be disposed on the bending region BA. The first protruding portion PR1 may be disposed on the second wiring portion 221.

The protective layer 300 may have various thicknesses for each region. In detail, the first protruding portion PR1 has a first thickness T1. Regions other than the protruding portion have a second thickness T2.

The first thickness T1 is a maximum thickness of the first protruding portion PR1. The first thickness T1 is a distance from an upper surface of the second wiring portion 221 to a peak point PK of the first protruding portion PR1. That is, the first thickness T1 is a maximum thickness of the first protruding portion PR1. The second thickness T2 is a distance from the upper surface of the second wiring portion 221 to the protective layer 300.

The first thickness T1 is greater than the second thickness T2. That is, the thickness of the protective layer of a region corresponding to the protruding portion is greater than the thickness of the protective layer of the other region.

The first thickness T1 may be 1 to 3 times, 1.2 to 2.5 times, or 1.4 to 2 times the second thickness T2.

For example, the first thickness T1 may be greater than 10 um. In detail, the first thickness T1 may be 10 um to 30 um, 12 um to 25 um, or 14 um to 20 um.

If the first thickness T1 is 10 um or less, the protective layer 300 may be peeled off by the sealing layer 5000. Accordingly, a portion of the second wiring portion 221 may be exposed to an outside. Accordingly, the second wiring portion 221 may be corroded, thereby reducing the reliability of the flexible circuit board 1000.

If the first thickness T1 exceeds 30 um, a size of the flexible circuit board 1000 may increase due to the protective layer 300. As a result, a curvature of the flexible circuit board 1000 may increase, and a process of manufacturing the COF module may become difficult. In addition, a size of a display device to which the COF module is applied may increase.

The protective layer 300 includes a region whose thickness varies due to the protruding portion. Accordingly, the thickness of the protective layer 300 is calculated as an average thickness. The average thickness of the protective layer 300 is greater than the second thickness T2. For example, the average thickness of the protective layer 300 may be more than 1 time the second thickness T2. For example, the average thickness of the protective layer 300 may be more than 10 µm.

The first thickness T1 is greater than the average thickness of the protective layer 300. In detail, a difference between the first thickness T1 and the average thickness of the protective layer 300 may be 5% to 100%, 7% to 50%, or 10% to 30% of the average thickness of the protective layer 300.

The peak point PK of the first protruding portion PR1 is disposed at a set position. A length of the fourth pad portion 222b is defined as a first length L1. In addition, a distance between the fourth pad portion 222b and the peak point PK is defined as a second-first length L2-1.

The second-first length L2-1 may be 5 times or less, 3 times or less, or 1 time or less of the first length L1. For example, the first length L1 may be 900 µm to 1200 µm. In addition, the second-first length L2-1 may be 500 µm to 600 µm.

A distance between the third pad portion 222a and the fourth pad portion 222b is defined as a third length L3.

One end of the fourth pad portion 222b may be defined as a starting point (0) of the third length, and one end of the third pad portion 222a may be defined as an ending point of the third length.

The peak point PK may be positioned within 2/3 or less, 1/3 or less, or 1/5 or less of the third length L3.

The first protruding portion PR1 is divided into the first region 1A and the second region 2A by the peak point PK. The first region 1A is a region where the thickness of the first protruding portion PR1 gradually increases. The second region 2A is a region where the thickness of the first protruding portion PR1 gradually decreases.

A length of the first region 1A is defined as the second-first length L2-1. A length of the second region 2A is defined as a second-second length L2-2.

The second-first length L2-1 and the second-second length L2-2 may be different. Therefore, in the first protruding region PR1, a region in which the thickness of the protruding region becomes thicker may be greater than the region in which the thickness becomes thinner.

Accordingly, the average thickness of the first protruding portion PR1 becomes thicker. Accordingly, when the first protruding portion PR1 and the sealing layer 500 come into contact, the first protruding portion PR1 can be prevented from being damaged.

The flexible circuit board includes a protective layer. The protective layer includes a region having a large thickness. In detail, the protective layer includes a first protruding portion. The first protruding portion is disposed in a region adjacent to the fourth pad portion.

The fourth pad portion is connected to the pad portion of the display panel. The protective layer in a region adjacent to the fourth pad portion can come into contact with the sealing layer. Accordingly, the first protruding portion is disposed in a region adjacent to the fourth pad portion. Accordingly, the sealing layer can come into contact with the first protruding portion. Accordingly, even if the protective layer is partially peeled off by the sealing layer, the protective layer can be prevented from being completely peeled off in the region in contact with the sealing layer.

Therefore, when connecting the flexible circuit board and the display panel, the circuit pattern of the flexible circuit board can be prevented from being exposed to the outside. Therefore, the reliability of the flexible circuit board and the COF module is improved.

The protective layer 300 may further include a protruding portion other than the first protruding portion. In detail, the protective layer 300 may include a second protruding portion PR2. The second protruding portion PR2 is disposed in a region adjacent to the chip mounting region CHA. The second protruding portion PR2 may extend along an edge of the chip mounting region CHA.

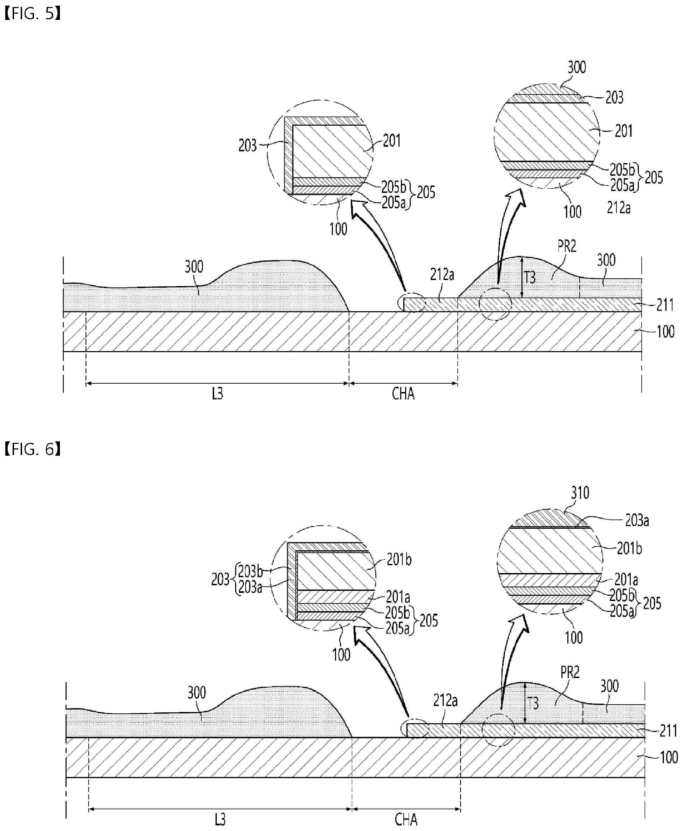

For example, referring to FIGS. 5 and 6, the second protruding portion PR2 may be disposed in a region adjacent to the first pad portion 212a. The second protruding portion PR2 has a third thickness T3. The third thickness T3 is a distance from the upper surface of the first wiring portion 211 to a peak point of the second protruding portion PR2.

Alternatively, the second protruding portion PR2 may be disposed in a region adjacent to the third pad portion 222a. In this case, the third thickness T3 may be a distance from the upper surface of the second wiring portion 221 to the peak point of the second protruding portion PR2.

A thickness of the protective layer of the region corresponding to the second protruding portion PR2 is greater than the thickness of the protective layer of the other region.

The third thickness T3 may be greater than 10 um. In detail, the third thickness T3 may be greater than 10um, 10um to 30 um, 12 um to 25 um, or 14 um to 20 um.

The third thickness T3 is greater than the average thickness of the protective layer 300. In detail, a difference between the third thickness T3 and the average thickness of the protective layer 300 may be 5% to 100%, 7% to 50%, or 10% to 30% of the average thickness of the protective layer 300.

The second protruding portion is disposed in a region adjacent to the chip mounting region. The chip is disposed on the chip mounting region using heat and pressure of a set size. The protective layer adjacent to the chip mounting region CHA may be damaged by the heat and pressure. The second protruding portion is disposed in a region adjacent to the chip mounting region CHA. Therefore, the protective layer of the region adjacent to the chip mounting region becomes thicker. Accordingly, the protective layer may be prevented from being damaged by heat and pressure when mounting the chip.

The first thickness T1 and the third thickness T3 may be the same or similar. Alternatively, the first thickness T1 and the third thickness T3 may be different. For example, the first thickness T1 may be greater than the third thickness T3.

That is, the thickness of the first protruding portion in contact with the sealing layer may be greater than the thickness of the second protruding portion. Since the first protruding portion is in direct contact with the sealing layer, it is more likely to be damaged than the second protruding portion. Accordingly, the thickness of the first protruding portion is formed to be greater than the thickness of the second protruding portion.

The protective layer 300 may further include a protruding portion other than the first and second protruding portions. In detail, the protective layer 300 may include a third protruding portion PR3. The third protruding portion PR3 may be disposed in a region adjacent to an outermost pattern in the second direction. For example, the third protruding portion PR3 may be disposed in a region adjacent to the third circuit pattern 230.

Alternatively, a dummy pattern may be disposed between the third circuit pattern 230 and the cutting line CL. That is, a dummy pattern may be disposed between the third circuit pattern 230 and an end of the flexible circuit board. In this case, the third protruding portion PR3 may be disposed in a region adjacent to the dummy pattern.

That is, an outermost pattern may be at least one pattern among the third circuit pattern 230 and the dummy pattern.

In addition, the third protruding portion PR3 is disposed in a region adjacent to the cutting region CA. The third protruding portion PR3 may extend in a direction in which the third wiring portion 231 extends. In detail, the third protruding portion PR3 may extend along the first direction 1D.

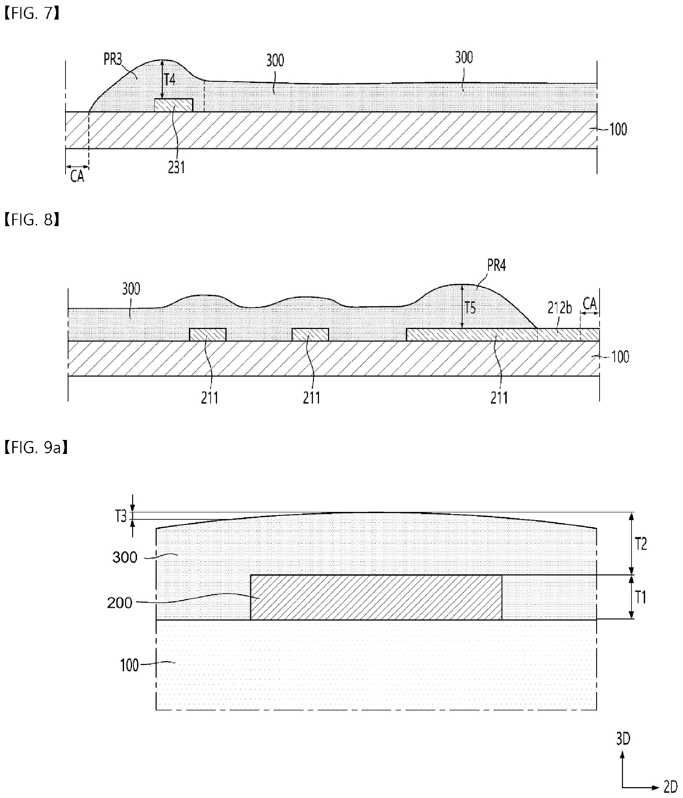

For example, referring to FIG. 7, the third protruding portion PR3 may be disposed in a region adjacent to the third wiring portion 231. The third protruding portion PR3 has a fourth thickness T4. The fourth thickness T4 is a distance from the upper surface of the third wiring portion 231 to a peak point of the third protruding portion PR3.

The thickness of the protective layer in the region corresponding to the third protruding portion PR3 is greater than the thickness of the protective layer in other regions.

The fourth thickness T4 may be greater than 10 um. In detail, the fourth thickness T4 may be greater than 10 um to 30 um, 12 um to 25 um, or 14 um to 20 um.

The fourth thickness T4 is greater than the average thickness of the protective layer 300. In detail, a difference between the third thickness T3 and the average thickness of the protective layer 300 may be 5% to 100%, 7% to 50%, or 10% to 30% of the average thickness of the protective layer 300.

The third protruding portion is disposed in a region adjacent to the cutting region. The cutting region is cut along a cutting line. The flexible circuit board can be cut with heat and/or pressure. For example, the flexible circuit board can be cut using a laser.

The protective layer adjacent to the cutting region can be damaged by the heat and/or pressure. The third protruding portion is disposed in a region adjacent to the cutting region. Therefore, the protective layer of the region adjacent to the cutting region becomes thicker. Accordingly, the protective layer can be prevented from being damaged by heat and pressure when cutting the flexible circuit board.

The first thickness T1, the third thickness T3, and the fourth thickness T4 can be the same or similar. Alternatively, the first thickness T1 and the third thickness T3 can be different, and the third thickness T3 and the fourth thickness T4 can be the same or similar. For example, the first thickness T1 can be greater than the fourth thickness T4.

That is, the thickness of the first protruding portion in contact with the sealing layer may be greater than the thickness of the third protruding portion. Since the first protruding portion is in direct contact with the sealing layer, it is more likely to be damaged than the third protruding portion. Accordingly, the thickness of the first protruding portion is formed to be greater than the thickness of the third protruding portion.

The third protruding portion PR3 may be in contact with the first protruding portion PR1. In addition, the third protruding portion PR3 may be spaced apart from the second protruding portion PR2. For example, the third protruding portion PR3 and the first protruding portion PR1 may be connected.

The protective layer 300 may further include a protruding portion other than the first to third protruding portions. In detail, the protective layer 300 may include a fourth protruding portion PR4. The fourth protruding portion PR4 is disposed in a region adjacent to the first circuit pattern 210. The fourth protruding portion PR4 may extend in a direction in which the third pad portions 212b are disposed.

In detail, the fourth protruding portion PR4 may extend in the second direction 2D. The fourth protruding portion PR4 is disposed between the first pad portion 212a and the second pad portion 212b. The fourth protruding portion PR4 may be disposed between the second pad portion 212b and the chip mounting region CHA. The fourth protruding portion PR4 may be disposed on the first wiring portion 211.

For example, referring to FIG. 8, the fourth protruding portion PR4 may be disposed in a region adjacent to the second pad portion 212b. The fourth protruding portion PR4 has a fifth thickness T5. The fifth thickness T5 is a distance from the upper surface of the first wiring portion 211 to a peak point of the fourth protruding portion PR4.

The thickness of the protective layer of the region corresponding to the fourth protruding portion PR4 is greater than the thickness of the protective layer of the other region.

The fifth thickness T5 may be greater than 10 um. In detail, the fourth thickness T4 may be greater than 10 um to 30 um, 12 um to 25 um, or 14 um to 20 um.

The fifth thickness T5 is greater than the average thickness of the protective layer 300. In detail, a difference between the fifth thickness T5 and the average thickness of the protective layer 300 may be 5% to 100%, 7% to 50%, or 10% to 30% of the average thickness of the protective layer 300.

The fourth protruding portion is disposed in a region adjacent to the cutting region. The cutting region is cut along a cutting line. The flexible circuit board may be cut with heat and/or pressure. For example, the flexible circuit board may be cut using a laser.

The protective layer adjacent to the cutting region may be damaged by the heat and/or pressure. The fourth protruding portion is disposed on a region adjacent to the cutting region. Therefore, the protective layer of the region adjacent to the cutting region becomes thicker. Accordingly, the protective layer may be prevented from being damaged by heat and pressure when cutting the flexible circuit board.

The first thickness T1, the third thickness T3, the fourth thickness T4, and the fifth thickness T5 may be the same or similar. Alternatively, the first thickness T1 and the fifth thickness T5 may be different, and the third thickness T3, the fourth thickness T4, and the fifth thickness T5 may be the same or similar. For example, the first thickness T1 may be greater than the fifth thickness T5.

That is, the thickness of the first protruding portion in contact with the sealing layer may be greater than the thickness of the fourth protruding portion. Since the first protruding portion directly contacts the sealing layer, it is more likely to be damaged than the fourth protruding portion. Accordingly, the thickness of the first protruding portion is formed to be greater than the thickness of the fourth protruding portion.

The fourth protruding portion PR4 may be in contact with the third protruding portion PR3. In addition, the fourth protruding portion PR4 may be spaced apart from the first protruding portion PR1 and the second protruding portion PR2. For example, the third protruding portion PR3 and the fourth protruding portion PR4 can be connected.

Accordingly, the first protruding portion PR1, the third protruding portion PR3, and the fourth protruding portion PR4 extend along the edge of the protective layer 300. Accordingly, a protruding portion can be formed at all edges of the protective layer 300.

Accordingly, the flexible circuit board 1000 can be prevented from being bent by the protruding portions. The edge of the flexible circuit board 1000 is more likely to be bent than other regions. Since a plurality of protruding portions are disposed at the edge of the flexible circuit board 1000, the edge of the flexible circuit board can be fixed by the plurality of protruding portions. Accordingly, the edge of the flexible circuit board can be prevented from being bent in one direction.

In addition, the chip mounting region CHA is more likely to be bent than other regions. Since a plurality of protruding portions are disposed at the edge of the flexible circuit board 1000, the edge of the flexible circuit board can be fixed by the second protruding portions. Accordingly, the chip mounting region can be prevented from being bent in one direction.

The circuit pattern is formed in a multilayer structure. The following description is equally applied to the second and third circuit patterns.

Referring to FIG. 5, the first circuit pattern is formed in a multilayer structure. In detail, the first wiring portion 211, the first pad portion 212a, and the second pad portion 212b include a buffer layer 205, a metal layer 201, and a bonding layer 203.

The buffer layer 205 may include a multilayer structure. In detail, the buffer layer 205 includes a first buffer layer 205a and a second buffer layer 205b. The first buffer layer 205a is disposed on the substrate 100. The second buffer layer 205b is disposed on the first buffer layer 205a.

The first buffer layer 205a includes a material having good adhesion to the substrate 100. For example, the first buffer layer 205a may include nickel (Ni). In addition, the second buffer layer 205b includes a material having good adhesion to the first circuit pattern. For example, the second buffer layer 205b may include chromium (Cr).

The buffer layer 205 may have a thin film thickness in nanometer units. For example, the buffer layer 205 may have a thickness of 20 nm or less.

The adhesion between the substrate 100 and the first circuit pattern is improved by the buffer layer 205.

The metal layer 201 is disposed on the buffer layer 205. In detail, the metal layer 201 is disposed on the second buffer layer 205b. The metal layer 201 includes a metal material. For example, the metal layer 201 may include copper (Cu).

The metal layer 201 may be formed by electroplating using a buffer layer as a seed layer. That is, the metal layer 201 may be a plating layer.

A thickness of the metal layer 201 may be 10 um to 30 um.

The bonding layer 203 is disposed on the metal layer 201.

The bonding layer 203 is disposed on a side surface and upper surface of the metal layer 201. For example, the bonding layer 203 may be disposed while surrounding the metal layer 201.

The bonding layer 203 includes a metal. For example, the bonding layer 203 may include tin (Sn).

A thickness of the bonding layer 203 may be 0.3 um to 0.7 um. A tin content of the bonding layer 203 may increase as it extends from a lower surface of the bonding layer 203 toward the upper surface of the bonding layer 203.

That is, the bonding layer 203 is in contact with the metal layer 201. Therefore, the tin content of the bonding layer 203 increases as it extends from the lower surface of the bonding layer 203 toward the upper surface of the bonding layer 203. In addition, a copper content decreases as it extends from the lower surface of the bonding layer 203 toward the upper surface of the bonding layer 203.

Accordingly, pure tin may remain in a thickness range of 0.1 um to 0.3 um from the upper surface of the bonding layer 203.

The pad portion can be easily bonded to the terminals of the chip, the circuit board, and the display panel by the bonding layer 203. For example, when heat and pressure are applied to the pad portion, the upper surface of the bonding layer melts. Pure tin remains on the upper surface of the bonding layer. Therefore, the pad portion can be easily bonded to the terminals of the chip, the circuit board, and the display panel.

Referring to FIG. 6, the metal layer 201 layer may include a first metal layer 201a and a second metal layer 201b. The first metal layer 201a is disposed on the buffer layer 205. The second metal layer 201b is disposed on the first metal layer 201a.

A thickness of the first metal layer 201a may be smaller than a thickness of the second metal layer 201b.

For example, the thickness of the first metal layer 201a may be 0.7 um to 2 um, and the thickness of the second metal layer 201b may be 10 um to 25 um.

The first metal layer 201a and the second metal layer 201b may include the same metal material. For example, the first metal layer 201a and the second metal layer 201b may include copper (Cu).

The first metal layer 201a and the second metal layer 201b may be formed through a plating process. For example, the first metal layer 201a is formed thinly on the buffer layer 205. Then, the second metal layer 201b may be formed using the first metal layer 201a as a seed layer.

In addition, the bonding layer 203 may include a first bonding layer 203a and a second bonding layer 203b.

The first bonding layer 203a is disposed on the metal layer 201. In detail, the first bonding layer 203a is disposed on the first wiring portion 211, the first pad portion 212a, and the second pad portion 212b.

The second bonding layer 203b is disposed on the first bonding layer 203a. In detail, the second bonding layer 203b is disposed on the first pad portion 212a and the second pad portion 212b.

Therefore, the first wiring portion 211 includes the buffer layer 205, the metal layer 201, and the first bonding layer 203a. In addition, the first pad portion 212a and the second pad portion 212b include a buffer layer 205, a metal layer 201, a first bonding layer 203a, and a second bonding layer 203b.

Therefore, a layer structure of the first wiring portion 211 is different from layer structures of the first pad portion 212a and the second pad portion 212b.

The first bonding layer 203a and the second bonding layer 203b include metal. In detail, the first bonding layer 203a and the second bonding layer 203b may include tin (Sn).

The first bonding layer 203a and the second bonding layer 203b are disposed with different thicknesses. In detail, the thickness of the second bonding layer 203b is greater than the thickness of the first bonding layer 203a.

For example, the first bonding layer 203a has a thickness of 0.02 um to 0.06 um. In addition, the second bonding layer 203b has a thickness of 0.2 um to 0.6 um.

Therefore, the thickness of the first wiring portion 211 becomes thin. Therefore, when the flexible circuit board is bent, cracks in the first wiring portion 211 can be prevented.

The thickness of the first circuit pattern can be 2 um to 25 um. In detail, the thickness of the first circuit pattern can be 5 um to 20 um. In detail, the thickness of the first circuit pattern can be 7 um to 15 um.

If the thickness of the first circuit pattern is less than 2 um, the resistance of the first circuit pattern can increase. If the thickness of the first circuit pattern exceeds 25 um, it becomes difficult to implement a fine pattern.

A flexible circuit board according to an embodiment includes a protective layer. The protective layer may include a first protruding portion. The first protruding portion is disposed between a third pad portion and a fourth pad portion. The first protruding portion is disposed in a region adjacent to the fourth pad portion. A thickness of the first protruding portion is greater than that of other regions of the protective layer.

At this time, the flexible circuit board is bent and connected to the pad portion of the display panel. At this time, a protective layer and a sealing layer of the display panel may come into contact. The protective layer prevents peeling of a contact region by the first protruding portion. Accordingly, the reliability of the flexible circuit board is improved.

In addition, the protective layer may further include a plurality of protruding portions. The protective layer may further include a second protruding portion. The second protruding portion extends along an edge of a chip mounting region. A thickness of the second protruding portion is greater than that of the other regions. Accordingly, when mounting a chip on the chip mounting region, the protective layer can be prevented from being damaged.

In addition, the protective layer may further include a third protruding portion. The third protruding portion is disposed in a region adjacent to the outermost pattern in the second direction. A thickness of the third protruding portion is greater than that of the other regions. Accordingly, when cutting the flexible circuit board, the protective layer can be prevented from being damaged.

In addition, the protective layer may further include a fourth protruding portion. The fourth protruding portion is disposed in a region adjacent to the second pad portion. A thickness of the fourth protruding portion is greater than that of the other regions. Accordingly, when cutting the flexible circuit board, the protective layer can be prevented from being damaged.

Meanwhile, a flexible circuit board according to another embodiment will be described below.

Hereinafter, different parts will be described with reference to the flexible circuit board according to the first embodiment described with reference to FIGS. 1 to 8. Hereinafter, for convenience of explanation, the flexible circuit board of the second embodiment will be described by assigning the same drawing references as those assigned to the flexible circuit board of the first embodiment.

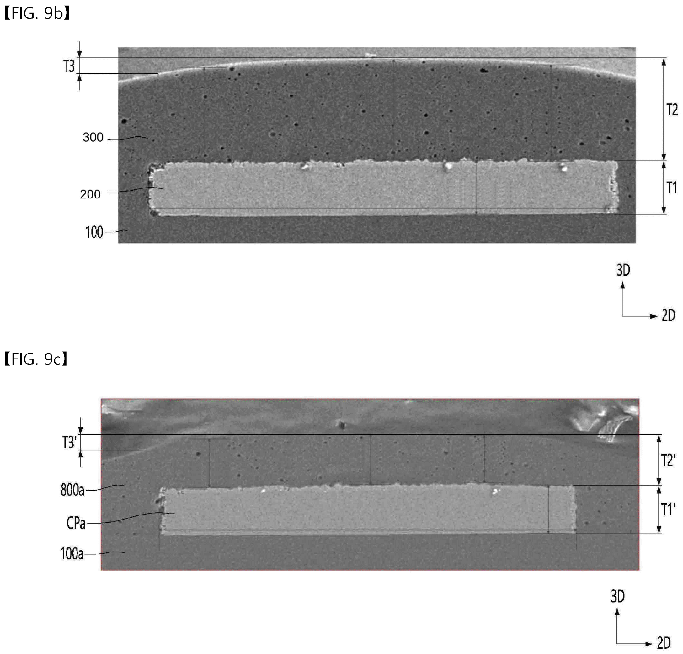

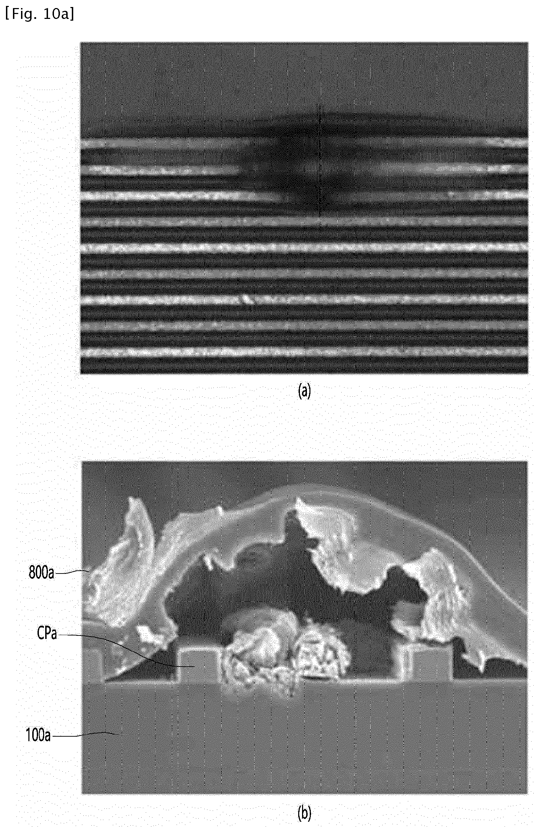

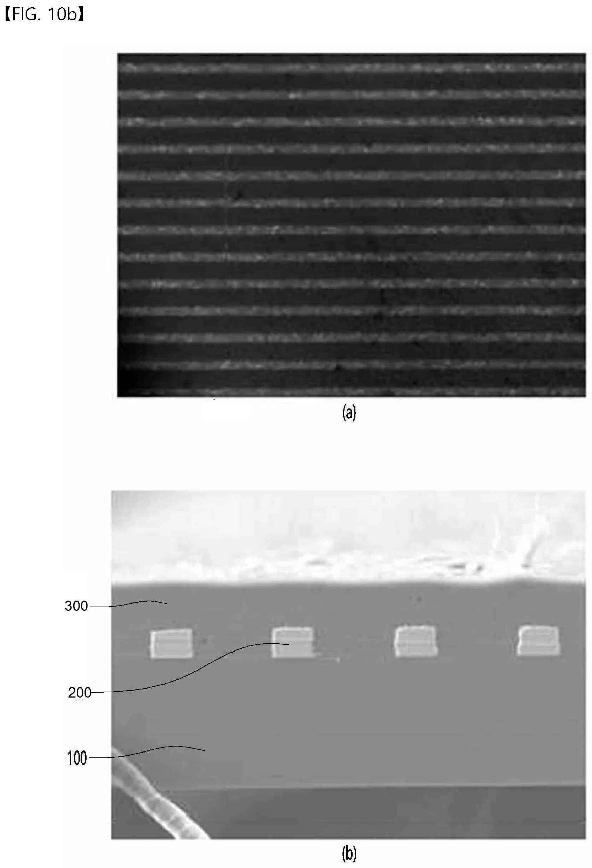

FIG. 9a is an enlarged cross-sectional view of a region E of FIG. 3 according to a second embodiment, FIG. 9b is a drawing showing a scanning electron microscope photograph of FIG. 9a according to a second embodiment, FIG. 9c is a drawing showing a scanning electron microscope photograph of a region E of FIG. 9b according to a comparative example, FIG. 10a is a drawing showing an analysis image of a protective layer of a flexible circuit board according to a comparative example, and FIG. 10b is a drawing showing an analysis image of a protective layer of a flexible circuit board according to a second embodiment.

As described above, the protective layer 300 may be disposed on the substrate 100 and the circuit pattern 200 with a certain height. The upper surface of the protective layer 300 may have a step. The upper surface of the protective layer 300 may have a curve. For example, the protective layer 300 may include an overlapping region that overlaps the circuit pattern 200 along a vertical direction, and a non-overlapping region that does not overlap the circuit pattern 200 along the vertical direction.

A height of the overlapping region of protective layer 300 may be greater a height of the non-overlapping region of protective layer 300. Furthermore, an upper surface of the overlapping region of the protective layer 300 may have a step. For example, the upper surface of the overlapping region of the protective layer 300 may have a curve. However, in the embodiment, a thickness of the protective layer 300, a concentration of a curing agent of the protective layer 300, and curing conditions of the protective layer 300 are changed to improve the adhesion between the protective layer 300 and the substrate 100 and the circuit pattern 200, thereby improving the mechanical reliability and/or electrical reliability of the flexible circuit board.

The protective layer 300 according to the second embodiment may have a thickness that is increased in a vertical direction, a higher concentration of the curing agent, and further an increased curing time compared to the protective layer of the comparative example. Through this, the embodiment allows for increasing the penetration time of moisture or contaminants along the direction from the upper surface of the protective layer 300 to the lower surface of the protective layer 300 in a high temperature or high humidity environment. That is, a problem of peeling of the protective layer 300 such as lifting may occur as moisture or contaminants penetrate into an interface between the protective layer 300 and the substrate 100, or an interface between the protective layer 300 and the circuit pattern 200. Therefore, the embodiment may delay the penetration of moisture or contaminants by increasing the thickness of the protective layer 300, thereby further improving the adhesion between the protective layer 300, the substrate 100, and the circuit pattern 200.

In addition, the embodiment can increase the concentration of a curing agent constituting the protective layer 300 compared to the comparative example.

That is, the protective layer 300 can be a resist layer. For example, the protective layer 300 can be a solder resist layer including an organic polymer material. As an example, the protective layer 300 can include an epoxy acrylate series resin. In detail, the protective layer 300 can include a resin, a curing agent, a photo initiator, a pigment, a solvent, a filler, an additive, an acrylic series monomer, etc. At this time, in the embodiment, the concentration of the curing agent provided in the protective layer 300 is increased by 30% or more compared to the concentration of the curing agent in the comparative example. Accordingly, the embodiment can minimize uncured components in the materials constituting the protective layer 300. In addition, the embodiment increases the concentration of the curing agent of the protective layer 300 to increase the polymer chain quality, thereby minimizing the penetration of moisture or contaminants due to the decrease in volume within the protective layer 300.

In addition, the embodiment can change the curing conditions of the protective layer 300.

For example, in the comparative example, a curing temperature of 140 degrees and a curing time of 40 minutes were applied as the curing conditions of the protective layer 300. In this case, the protective layer 300 is not completely cured and a content of an uncured component increases, which may increase the volume within the protective layer 300 and increase the space through which moisture or contaminants can penetrate within the protective layer 300. In contrast, the embodiment can apply a curing temperature of 140 degrees and a curing time of 60 minutes as the curing conditions of the protective layer 300. In this case, the protective layer 300 can be cured more completely, thereby minimizing the content of uncured components within the protective layer 300, thereby reducing the volume within the protective layer 300. Furthermore, the embodiment can increase the cross-link bonding strength through the strengthening of the curing of the protective layer 300. Therefore, the embodiment can delay the structural destruction of the protective layer 300 due to migration, and further delay the migration growth.

Through the increase in the thickness of the protective layer 300, the increase in the curing agent concentration, and the change in the curing conditions in the present invention as described above, the protective layer 300 in the embodiment can have the following structure and be disposed on the substrate 100 and the circuit pattern 200.

Specifically, referring to FIGS. 9a and 9b, the circuit pattern 200 is disposed on the substrate 100. The circuit pattern 200 may be any one of the first circuit pattern, the second circuit pattern, the third circuit pattern, and the dummy pattern described in the previous embodiment.

In addition, a protective layer 300 is disposed on the circuit pattern 200. The protective layer 300 may be disposed on the circuit pattern 200 with a certain height or thickness.

The circuit pattern 200 may have a first thickness T1. The first thickness T1 of the circuit pattern 200 may mean a vertical distance between the upper surface of the circuit pattern 200 and the lower surface of the circuit pattern 200.

The first thickness T1 of the circuit pattern 200 may have a thickness of 2 um to 25 um. Preferably, the first thickness T1 of the circuit pattern 200 may have a thickness of 4 um to 20 um. More preferably, the first thickness T1 of the circuit pattern 200 may have a thickness of 5 um to 12 um.

If the first thickness T1 of the circuit pattern 200 is less than 2 um, processability in a process of manufacturing the flexible circuit board may be deteriorated, and thus the product yield may be degraded. In addition, if the first thickness T1 of the circuit pattern 200 is less than 2 um, an allowable current of the signal transmitted through the circuit pattern 200 may be reduced. In addition, if the first thickness T1 of the circuit pattern 200 is less than 2 um, a resistance of the circuit pattern 200 may increase. In addition, if the first thickness T1 of the circuit pattern 200 exceeds 25 um, it may be difficult to miniaturize the circuit pattern 200. In addition, if the first thickness T1 of the circuit pattern 200 exceeds 25 µm, a thickness of flexible circuit board increases, and it may be difficult to make them slimmer.

More preferably, the circuit pattern 200 may have a thickness of 7 µm to 10 µm to reduce resistance and increase allowable current while enabling the implementation of a fine pattern.

The protective layer 300 may be provided on the circuit pattern 200 with a second thickness T2 different from the first thickness T1. The second thickness T2 of the protective layer 300 may mean a vertical distance between an upper surface of the protective layer 300 and a lower surface of the protective layer 300.

A second thickness T2 of the protective layer 300 may exceed 10 µm. Preferably, the second thickness T2 of the protective layer 300 may exceed 12 µm. More preferably, the second thickness T2 of the protective layer 300 may exceed 14 µm.

For example, the second thickness T2 of the protective layer 300 may satisfy a range of 11 µm to 30 µm. Preferably, the second thickness T2 of the protective layer 300 may satisfy a range of 12 µm to 25 µm. More preferably, the second thickness T2 of the protective layer 300 may satisfy a range of 13 µm to 20 µm.

If the second thickness T2 of the protective layer 300 is less than 11 µm, a vertical distance between the protective layer 300 and the substrate 100 and/or the circuit pattern 200 may decrease, thereby causing the protective layer 300 to be separated from the substrate 100 and/or the circuit pattern 200 due to penetration of moisture, contaminants, and/or metal ions.

In addition, if the second thickness T2 of the protective layer 300 exceeds 30 µm, the thickness of the flexible circuit board may increase. In addition, if the second thickness T2 of the protective layer 300 exceeds 30 µm, it may be difficult to form a protective layer 300 having a uniform thickness over an entire region of the flexible circuit board.

The protective layer 300 includes an overlapping region that overlaps the circuit pattern 200 along a vertical direction, and a non-overlapping region that does not overlap the circuit pattern 200 along the vertical direction.

The overlapping region of the protective layer 300 may be provided with a second thickness T2 in the above-described range from the upper surface of the circuit pattern 200. Here, the thickness of the overlapping region of the protective layer 300 may mean a vertical distance between the upper surface of the overlapping region of the protective layer 300 and the upper surface of the circuit pattern 200.

In addition, the non-overlapping region of the protective layer 300 may be provided with a second thickness T2 in the above-described range from the upper surface of the substrate 100. Preferably, the thickness of the non-overlapping region of the protective layer 300 may mean a vertical distance between the upper surface of the substrate 100 and the upper surface of the non-overlapping region of the protective layer 300. And, the thickness of the non-overlapping region of the protective layer 300 may be different from the thickness of the overlapping region of the protective layer 300. Preferably, the thickness of the non-overlapping region of the protective layer 300 may be greater than the thickness of the overlapping region of the protective layer 300. This may mean that the vertical distance between the upper surface of the non-overlapping region of the protective layer 300 and the upper surface of the overlapping region of the protective layer 300 is smaller than the vertical distance between the upper surface of the circuit pattern 200 and the lower surface of the non-overlapping region of the protective layer 300.

At this time, a height of the upper surface of the protective layer 300 may be rapidly reduced depending on a first thickness T1 of the circuit pattern 200 or a height of the upper surface of the circuit pattern 200 in a boundary region between the overlapping region and the non-overlapping region of the protective layer 300. At this time, in the embodiment, as described above, the thickness of the protective layer 300 is increased compared to the comparative example, the concentration of the curing agent is increased, and the curing time is increased, thereby preventing the height of the protective layer 300 from rapidly reducing in the boundary region described above.

In addition, the thickness of the protective layer 300 in the overlapping region (the vertical distance between the upper surface of the overlapping region of the protective layer and the upper surface of the circuit pattern) may be greater than the thickness of the circuit pattern (the vertical distance between the lower surface of the circuit pattern and the upper surface of the circuit pattern). Preferably, the thickness in the overlapping region of the protective layer 300 may be 1.2 times or more, 1.5 times or more, or 1.8 times or more the thickness of the circuit pattern 200. Preferably, the thickness in the overlapping region of the protective layer 300 may have a range of 1.2 to 10 times, 1.5 to 8 times, or 1.8 to 7 times the thickness of the circuit pattern 200. If the thickness in the overlapping region of the protective layer 300 is less than 1.2 times the thickness of the circuit pattern 200, the difference between the height in the overlapping region of the protective layer 300 and the height in the boundary region may become large. In addition, if the thickness in the overlapping region of the protective layer 300 exceeds 10 times the thickness of the circuit pattern 200, a thickness of flexible circuit boards increases, and it may be difficult to make them slimmer.

In addition, the thickness in the boundary region of the protective layer 300 (a vertical distance between the upper surface of the boundary region of the protective layer and the upper surface of the circuit pattern) may be greater than or equal to the thickness of the circuit pattern 200 (the vertical distance between the lower surface of the circuit pattern and the upper surface of the circuit pattern). Preferably, the thickness in the boundary region of the protective layer 300 may be 1 time or more, 1.2 times or more, or 1.5 times or more the thickness of the circuit pattern 200. Preferably, the thickness at the boundary region of the protective layer 300 may have a range of 1 to 8 times, 1.2 to 7 times, or 1.5 to 6 times the thickness of the circuit pattern 200. If the thickness in the boundary region of the protective layer 300 is less than 1 time the thickness of the circuit pattern 200, the difference between the height at the boundary region of the protective layer 300 and the height in the overlapping region may become large. In addition, if the thickness at the boundary region of the protective layer 300 exceeds 10 times the thickness of the circuit pattern 200, the thickness of the flexible circuit board increases, and it may be difficult to make them slimmer.

For example, according to the comparative example of FIG. 9c, the circuit pattern CPa has a thickness T1' of 6 um to 9 um, and the protective layer 800a has a thickness T2' in a range of 8 um to 10 um on the circuit pattern CPa. Accordingly, in the comparative example, the height difference T3' between the overlapping region and the boundary region of the protective layer 800a is increasing. And, as the height difference T3' described above increases, the height at the overlapping region of the protective layer 800a may decrease. In this case, since the vertical distance between the protective layer 800a and the circuit pattern CPa is not secured, problems of moisture, contaminants, and metal ions penetrating may occur. In addition, as the height difference T3' described above increases, moisture, contaminants, and metal ions may penetrate into the above-described boundary region, which may cause a lifting problem of the protective layer 800a.

Specifically, in the comparative example, the height difference T3' exceeded 35%, 40%, or 45% of the thickness of the circuit pattern 200.

In contrast, the embodiment increases the thickness of the protective layer 300, increases the concentration of the curing agent, and increases the curing time, thereby preventing the height of the protective layer 300 from rapidly decreasing in the above-described boundary region.

For example, a height difference T3 between the boundary region and the overlapping region of the protective layer 300 may be less than 30%, less than 25%, less than 20%, less than 15%, or less than 12% of the first thickness T1 of the circuit pattern 200.

Through this, the embodiment can minimize the height difference T3 between the boundary region and the overlapping region of the protective layer 300, thereby effectively preventing moisture, contaminants, and metal ions from penetrating into the boundary region of the protective layer 300, and thereby further improving the adhesion between the protective layer 300, the substrate 100, and the circuit pattern 200.

Furthermore, the height difference T3 between the boundary region and the overlapping region of the protective layer 300 can be less than 20%, less than 15%, less than 10%, less than 8%, or less than 5% of the thickness in the overlapping region of the protective layer 300 or the vertical distance between the upper surface of the overlapping region of the protective layer 300 and the upper surface of the circuit pattern 200. Here, the thickness or vertical distance in the overlapping region of the protective layer 300 can vary along the horizontal direction. In this case, the thickness or vertical distance in the overlapping region of the protective layer 300 may mean the maximum thickness or maximum vertical distance in the overlapping region of the protective layer 300. Preferably, the thickness or vertical distance in the overlapping region of the protective layer 300 may mean a maximum thickness or maximum vertical distance in the overlapping region of the protective layer 300 in the cross-section in the width direction of the circuit pattern 200.

Referring to (a) and (b) of FIG. 10a, in the comparative example, as described above, a height difference T3' in the boundary region is large, and accordingly, moisture, contaminants, and metal ions easily penetrate into the protective layer 800'. As a result, a problem occurs in which the protective layer 800' is separated from the substrate 100' and/or the circuit pattern 200.

In contrast, referring to (a) and (b) of FIG. 10b, in the embodiment, as described above, by minimizing the height difference T3 in the boundary region, it is possible to easily prevent moisture, contaminants, and metal ions from penetrating into the protective layer 300, thereby solving the problem of the protective layer 300 being separated from the substrate 100 and/or the circuit pattern 200.

The protective layer according to the embodiment may have a thickness that is increased in a vertical direction, a higher concentration of a curing agent, and further an increased curing time, compared to the protective layer of the comparative example. Through this, the embodiment can allow for increasing a penetration time of moisture or contaminants from the upper surface of the protective layer to the lower surface of the protective layer in a high temperature or high humidity environment. In other words, a problem such as peeling of the protective layer can occur when moisture or contaminants penetrate an interface between the protective layer and the substrate, or an interface between the protective layer and the circuit pattern. Therefore, the embodiment can delay the penetration of moisture or contaminants by increasing the thickness of the protective layer, thereby further improving the adhesion between the protective layer, the substrate, and the circuit pattern.

In addition, the embodiment can increase the concentration of the curing agent that constitutes the protective layer compared to the comparative example. That is, in the embodiment, the concentration of the curing agent provided in the protective layer is increased by 30% or more compared to the concentration of the curing agent in the comparative example. Accordingly, the embodiment can minimize uncured components in materials that constitute the protective layer. Furthermore, the embodiment increases the concentration of the curing agent in the protective layer to increase a polymer chain quality, thereby minimizing the penetration of moisture or contaminants due to a volume reduction within the protective layer.

Furthermore, the embodiment can change curing conditions of the protective layer. That is, the embodiment can increase a curing time of the protective layer, thereby minimizing a content of uncured components within the protective layer, thereby reducing a volume within the protective layer. Furthermore, the embodiment can increase a cross-link bonding strength through the strengthening of the curing of the protective layer. Therefore, the embodiment can delay structural destruction of the protective layer due to migration, and further delay migration growth.

In addition, the embodiment can increase the thickness of the protective layer, increase the concentration of the curing agent, and increase the curing time, thereby preventing the rapid decrease in the height of the protective layer in the above-described boundary region. That is, the embodiment can minimize the height difference between the boundary region and the overlapping region of the protective layer, thereby effectively preventing moisture, contaminants, and metal ions from penetrating into the boundary region of the protective layer, and thereby further improving the adhesion between the protective layer, the substrate, and the circuit pattern.

Therefore, the embodiment can provide a protruding portion in an outermost non-overlapping region of the protective layer. Here, the protruding portion can be a protruding surface protruding upward from the upper surface of the protective layer. At this time, a height of the protruding portion can be greater than the height of other regions of the protective layer. Specifically, the height of the protruding portion of the protective layer can be greater than a height of the overlapping region of the protective layer. For example, the protruding portion of the protective layer can have the largest height or thickness in the entire region of the protective layer. Through this, the embodiment can easily prevent moisture, contaminants, and metal ions from penetrating through the outermost overlapping region of the protective layer.

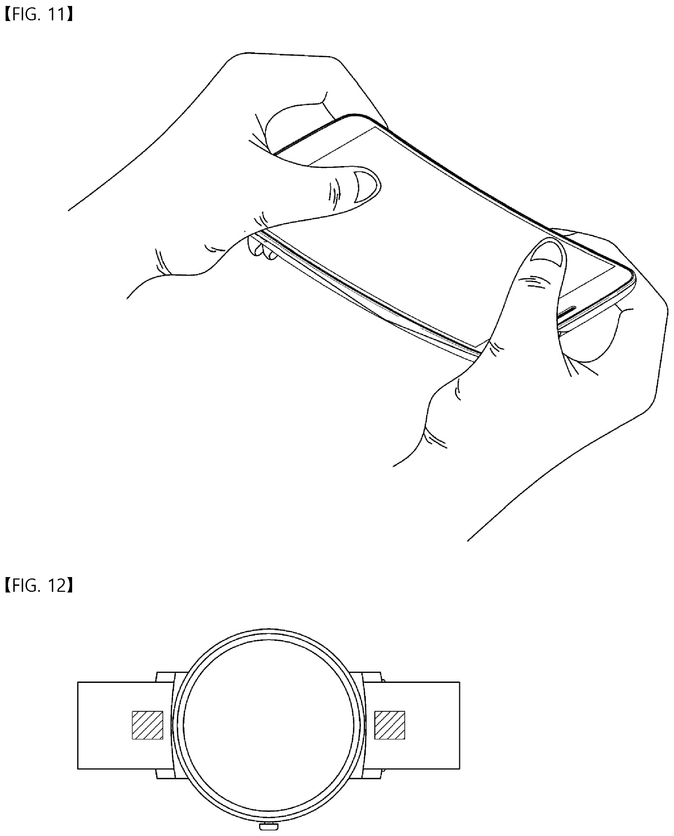

FIGS. 11 to 13 are drawings of an electronic device including a flexible circuit board according to an embodiment.

Since the COF module is flexible, it can be used in various electronic devices.

For example, referring to FIG. 11, the COF module can be included in a flexible touch window that bends. Accordingly, a touch device including it can be a flexible touch device. Accordingly, a user can bend or fold it by hand. Such a flexible touch window can be applied to a wearable touch, etc.

Referring to FIG. 12, the COF module can be included in various wearable touch devices including a curved display. Accordingly, an electronic device including the COF module can be slimmed down or made lightweight.

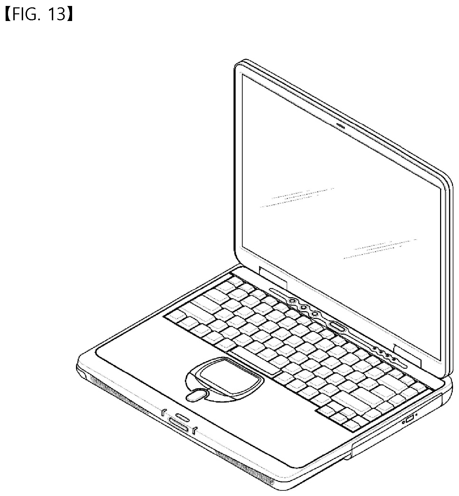

Referring to FIG. 13, the COF module can be used in various electronic devices having a display portion, such as a TV, a monitor, and a laptop. At this time, the COF module can also be used in an electronic device having a curved display portion.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A flexible circuit board comprising:
a substrate;
a circuit pattern disposed on the substrate; and
a protective layer disposed on the circuit pattern and including first to third openings,
wherein the circuit pattern includes:
a first circuit pattern including a first pad portion disposed in the first opening, a second pad portion disposed in the second opening, and a first wiring portion connecting between the first pad portion and the second pad portion, and
a second circuit pattern including a third pad portion disposed in the first opening, a fourth pad portion disposed in the third opening, and a second wiring portion connecting between the third pad portion and the fourth pad portion,
wherein the protective layer includes a first protruding portion having a first thickness provided in a region adjacent to the third wiring portion,
wherein the protective layer has a second thickness smaller than the first thickness in a region where the first protruding portion is not provided, and
wherein the first protruding portion is disposed between the third pad portion and the fourth pad portion and extends in a direction in which the fourth pad portion is disposed.

2. The flexible circuit board of claim 1, wherein the first thickness is more than 1 to 3 times the second thickness.

3. The flexible circuit board of claim 1, wherein the first thickness is more than 10um to 30um.

4. The flexible circuit board of claim 1, wherein the first thickness is 5% to 100% of an average thickness of the protective layer.

5. The flexible circuit board of claim 1, wherein the first protruding portion includes a peak point,
wherein the fourth pad portion has a first length,
wherein a distance between the fourth pad portion and the peak point has a second-first length, and
wherein the second-first length is 5 times or less the first length.

6. The flexible circuit board of claim 5, wherein a distance between the third pad portion and the fourth pad portion has a third length, and
wherein the peak point is positioned within 2/3 of the third length.

7. The flexible circuit board of claim 5, wherein the first protruding portion includes a first region in which a thickness increases and a second region in which the thickness decreases,
wherein the first region has the second-first length,
wherein the second region has a second-second length, and
wherein the second-first length is longer than the second-second length.

8. The flexible circuit board of claim 1, wherein the substrate includes a chip mounting region overlapping the first opening along a thickness direction,
wherein the protective layer further includes a second protruding portion provided in a region adjacent to the chip mounting region, and
wherein the second protruding portion extends along an edge of the chip mounting region.

9. The flexible circuit board of claim 8, wherein the second protruding portion has a third thickness, and
wherein the third thickness is greater than an average thickness of the protective layer.

10. The flexible circuit board of claim 9, wherein the third thickness is greater than the second thickness, and
wherein the first thickness is greater than the third thickness.
